# EUROPEAN PATENT APPLICATION

(11) **EP 1 908 727 A1**
(43) Date of publication of application: **09.04.2008**
(21) Application number: 06121695.8
(22) Date of filing: 03.10.2006
(51) Int. Cl.: B81C 5/00

(54) **Wafer-level MEMS package and manufacturing method thereof**

(71) Applicant: Seiko Epson Corporation, Shinjuku-ku, Tokyo 163-0811 (JP)
(72) Inventor: Carmona, Manuel, 08190, Sant Cugat del Vallés (Barcelona) (ES); Kihara, Ryuji Epson Europe Electronic GmbH, 08190 Sant Cugat del Vallés (Barcelona) (ES); Esteve, Jaume, 08193, Bellaterra (Barcelona) (ES)
(74) Representative: Carpintero Lopez, Francisco

(57) **Abstract**

The present invention is related in general to a wafer-level packaging technique for micro-electro-mechanical systems (MEMS). A cap structure (4) is provided encapsulating a MEMS element (1) formed on a base substrate (2). A channel (9) communicates etching holes (8,7) provided on said cap structure (4), for the passage of an etching fluid (12) to a chamber (3) in which the MEMS element is housed. The holes (8,7) are arranged in such a manner that they do not overlap, which allows the provision of a large number of etching holes above the MEMS element (1), but prevents a sealing material (10) from reaching the MEMS element. The invention provides a low cost wafer-level packaging technique for MEMS devices, that reduces the total etching time of the sacrificial material and provides a reinforced protective cap structure for the MEMS package.

## Description

### OBJECT OF THE INVENTION

The present invention is related in general to a wafer-level packaging technique for micro electro-mechanical systems (MEMS). More in particular the invention refers to a MEMS package and a method of manufacturing said MEMS package.

It is an object of the present invention to provide a low cost wafer-level packaging technique for MEMS devices, that reduces the total etching time of the sacrificial material, and provides a reinforced protective cap structure for the MEMS devices.

The present invention pertains generally to the technical field of fabrication of semiconductor devices.

### BACKGROUND TO THE INVENTION

Micro electro-mechanical systems (MEMS) are widely used in many applications, such as accelerometers, optical communications, biomedical systems etc. However, MEMS are not compatible with standard integrated circuit (IC) packaging technologies, because they include generally moving components or require specific atmospheric conditions such as vacuum, inert gas etc, for which standard packaging techniques used for integrated circuits can not be applied directly on MEMS devices. Then, MEMS need to be protected by a package before its integration in an IC package. For example, die sawing of the host wafer or an injection molding packaging process, would cause severe damages to movable parts of the MEMS if they are not protected.

Therefore, in the field of MEMS fabrication, packaging has always been an obstacle for commercialization, because it usually poses severe restrictions for fabrication and it always causes a significant increase of cost per device. In fact, the package represents a very large proportion of the total MEMS device cost.

There have been multiple approaches for packaging MEMS at different levels. The first level, so-called the zero-level or wafer-level (prior to dicing) refers to device packaging. In the wafer-level packaging for MEMS, two main approaches have been evaluated up to now: bonding and thin-film processing. The bonding approach generally uses a stacking process of different wafers. They are generally costly and bulky.

Thin-film processing approach uses surface-micromachining techniques for fabricating the package. Sometimes it uses additional processes or modifications of the existing ones. This is due to the general need of a thick layer for avoiding contact between package and the MEMS device when subjected to the difference of pressure between the outside ambient and the inner pressure (generally vacuum or nearly-vacuum).

It is generally required to have etching holes on the package cap to enable a release processing step and a later sealing step. The package cap is constructed on a sacrificial material deposited on the MEMS device, and subsequently an etching solution is applied to remove the sacrificial material to release the MEMS device. Etching holes are provided in the package cap to allow an etching solution to get access to the sacrificial material. As a final step of the process, a sealing material is applied to seal the etching holes. The etching holes can not be located above the MEMS device, because in that case part of the sealing material would be deposited on the MEMS causing severe damages on it. This technique is based on the use of peripheral holes located outside the MEMS area, which allows a relatively easy sealing step, but it has the major inconvenient of long etching times, which could be around 3 hours or longer due to the reduced number of etching holes that can be provided on the package cap, and due to the limited areas of the cap where the etching holes can be located.

Another approach has been the use of a thin layer permeable membrane to the etchant solution over the theoretical holes of the package. It has the advantage of obtaining a relatively fast etching time (because of the large number of holes over the whole surface of the package) but presents problems of reliability due to fabrication difficulties of the permeable membrane. Finally, another approach is using very small holes, through which the etchant solution can cross but not the later sealing material (due to its high viscosity). The main drawbacks of these techniques, are related to the restrictions of the sealing materials that can be used and the minimum hole size definition over the package.

Another problem of the thin-film approach is the pressure or deflection that the package can suffer. It has been solved by two different ways: building a thick layer and using posts connected to the substrate. Additionally, the package should also be able to withstand later processes, like, for example, a whole chip packaging process.

For the package sealing, different processes can be used. One group of techniques that could be used are those called PVD (Physical Vapor Deposition) processes. Among them, there is the evaporation technique and sputtering deposition. In both processes, the particles of the material are physically directed from the material source to the surface where it will be deposited. In this way, only externally viewable surfaces will be impacted by the material particles and therefore deposited.

The following references are related to the beforementioned prior-art packaging techniques:
B.H. Stark, K. Najafi, "A low-temperature thin-film electroplated metal vacuum package", Journal of Microelectromechanical Systems, Vol. 13, 2, 2004, pp. 147-157.
C. Gillot et al., "Wafer level thin film encapsulation for MEMS", Electronics Packaging Technology Conference, 2005.
T. Tsuchiya, "Polysilicon vibrating gyroscope vacuum-encapsulated in an on-chip micro chamber", Sensors and Actuators, A, 90 (2001), pp. 49-55.
A.J. Gallant, D. Wood, "Surface micromachined membranes for wafer level packaging", Journal of Micromechanics and Microengineering, 15 (2005), pp. S47-S52.

Packaging techniques for MEMS devices, are also described in the U.S. Patent Application US-20040028849 and in the U.S Patents US-4.996.082 and US-6.478.974.

### SUMMARY OF THE INVENTION

The present invention provides a thin-film packaging technique for MEMS, in which a cap structure formed by at least one protective layer, is provided encapsulating at least a MEMS element together with a base substrate on which the MEMS has been previously formed. The protective layer has at least one input hole on its upper surface and at least one output hole on its lower surface, and includes at least one channel which communicates said input and output holes for the passage of an etching fluid to said chamber to release the MEMS element.

The input and output holes are arranged in such a manner in the protective layer, that they do not overlap. The input and output holes of the protective layer are not aligned in a substantially orthogonal direction to the substrate, so that the channel that communicates said holes defines a non-straight access to the chamber inside which the MEMS is encapsulated.

In the MEMS package of the invention, the cap structure is provided with at least one non-straight conduit which allows the circulation of the etching solution due to its fluidity, but which prevents the passage of the sealing material which due to its viscosity, can not flow through said conduit due to the tortuous shape of the same and/or due to the fluidic resistance of the channel. The sealing material during its deposition, cannot find a straight access to the MEMS device, and consequently it is trapped in the cap structure. Said non-straight conduit or fluid passageway, is defined by the input and output holes of the protective layers and the channel that communicates them.

With this particular arrangement of the input and output holes, a large number of etching holes can be provided in the cap structure even above the MEMS device, without the risk of the sealing material reaching the MEMS device. Consequently, a large area of the sacrificial material is put in contact with the etching solution, hence the time required to eliminate the sacrificial material is reduced, thereby reducing also the cost of the packaging process.

This arrangement allows a fast etching process, and additionally allows the use of holes of a large area, thus further reducing the etching time and reducing the risk of any damage being caused to the MEMS during the etching process.

Another aspect of the invention refers to a method of manufacturing a MEMS package, which comprises the steps of forming a MEMS element on a base substrate by means of a conventional process, and forming a cap structure joined to said base substrate to encapsulate said MEMS element within a chamber. The cap structure comprises at least one protective layer having at least one input hole on its upper surface and at least one output hole on its lower surface. The protective layer also includes at least one channel which communicates said input and output holes, for the passage of an etching fluid to said chamber.

The input and output holes are arranged in such a manner that they do not overlap.

After the cap structure has been formed, an etching solution is applied through the holes and said channel to release the MEMS, and if required a sealing material is finally deposited to seal the input holes of the protective layer.

Due to the mismatched positions of the input and output holes at the top and bottom surfaces of the protective layer of the cap structure, the sealing process will avoid deposition of sealing material over the MEMS. This arrangement of the holes, also allows the use of etching holes above the location of area in which the MEMS is located, reducing the total etching time and therefore also reducing the cost of the package and the negative effects associated with long etching times.

If the thickness of the layer of the sealing material is thick enough, the sealing of the chamber would be always realized, independently of the holes dimensions.

This invention avoids the need of a bonding process. It is totally fabricated during the same fabrication process of the integrated circuit and MEMS. No additional wafers or external caps are used to package the MEMS.

An additional advantage is that the use of adhesive materials is not required, which could limit the reliability of the package.

The packaging technique described in this invention can be used for wafer level packaging of MEMS with the advantages of compatibility with standard IC fabrication techniques due to low temperature necessary to fabricate it, low fabrication cost, low etching times and no need of bonding processes.

### DESCRIPTION OF THE DRAWINGS

The features of the invention will be better understood by reference to the accompanying drawings, which illustrate preferred embodiments of the invention.
Figure 1.- shows a schematic representation of a cross-sectional view of the MEMS package object of the invention, after the etching process but before the sealing process.
Figure 2.- shows a schematic representation of a cross-sectional view of the MEMS package object of the invention, before the etching process. The figure illustrates the MEMS release process, in which the path followed by the etching solution is represented by arrows. The etching solution is represented in a figurative manner by a rectangular box.
Figure 3.- shows a schematic representation of the sealing process of the packaged MEMS, subsequent to the releasing process.
Figure 4.- shows a schematic representation of a packaged MEMS after the sealing process with a sealing material thick enough to fill the gap between both layers of package cap layers.
Figure 5.- shows a cross-sectional perspective view from above of an embodiment of the MEMS package of the present invention, after the releasing process but before sealing.
Figure 6.- shows a top plan view of the MEMS package of figure 5, in which the holes of the top protective layer are represented by squares, and the positions of the holes of the bottom layer are represented by dots.
Figure 7.- figure (7a) shows a cross-sectional perspective view of another embodiment of a MEMS package according to the present invention, after the releasing process but before the sealing the process. Top and bottom layers of the package cap, are physically connected at different points in order to increase the rigidity of the package. Figure (7b) shows a cross-sectional perspective view of the package cap in an inverted position.
Figure 8.- figures (8a) and (8b) are cross-sectional perspective view as figures (7a) and (7b), but with an alternative distribution of the holes of the top and bottom layers of the package cap.
Figure 9.- shows a figurative representation of a portion of the top and bottom layers of the package cap, which are physically connected at different locations by means of vertical posts or pillars to increase rigidity of the package.
Figure 10.- shows a figurative representation of a portion of a package cap with three layers, and the sealing material closing the hole of the upper layer. The MEMS element and the base substrate are omitted for the simplicity of the figure.
Figure 11.- shows a sequence of steps (a-1) for manufacturing a MEMS package in a conformal process according to the present invention.
Figure 12.- shows a sequence of steps (a-1) for manufacturing a MEMS package in a planar process,
Figure 13.- shows the last three steps (i-k) for manufacturing a MEMS package with post-processing.

### DETAILED DESCRIPTION OF PREFERRED EMBODIMENTS

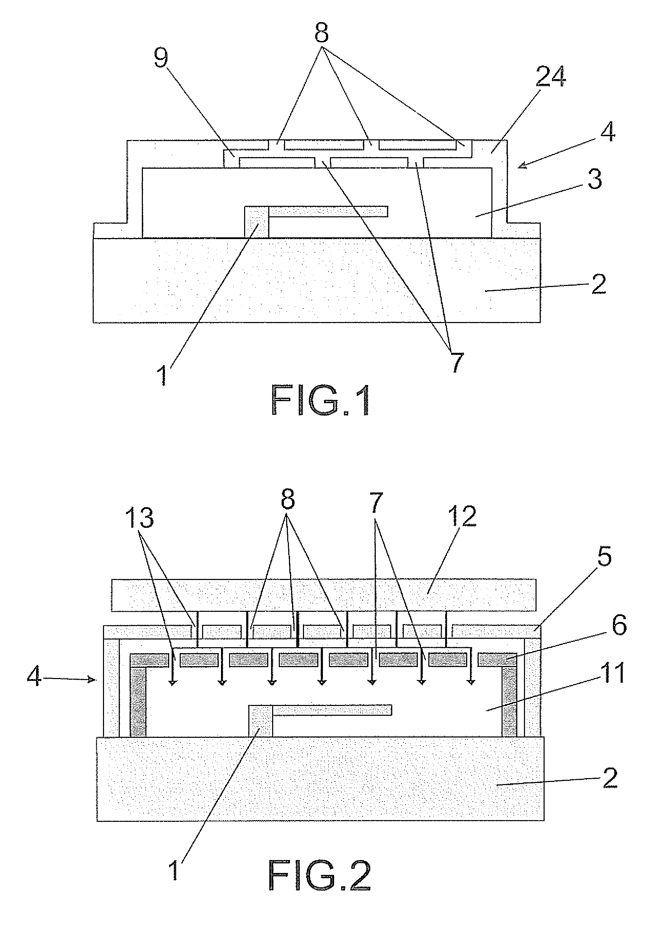

An exemplary embodiment of a MEMS package object of the invention is represented in figure 1, in which at least one MEMS element (1) is formed in a known manner on a base substrate (2). Preferably, the base substrate (2) is a semiconductor substrate, for example an oxidized silicon wafer, and the MEMS element (1) is formed on a planer surface of the base substrate (2).

The MEMS package comprises a cap structure (4) joined to said base substrate (2), forming a chamber (3) together with said substrate so that the MEMS element (1) is encapsulated within said chamber (3). The cap structure (4) is formed by a single protective layer (24) having a plurality of input holes (8) on its upper surface and a plurality of output holes (7) on its lower surface. The protective layer (24) includes a channel (9) which communicates said input and output holes (8,7) for the passage of an etching fluid (12) to said chamber (3). The input and output holes (8,7) are located in such a manner that they do not overlap in order to prevent a sealing material (10) from reaching the chamber (3).

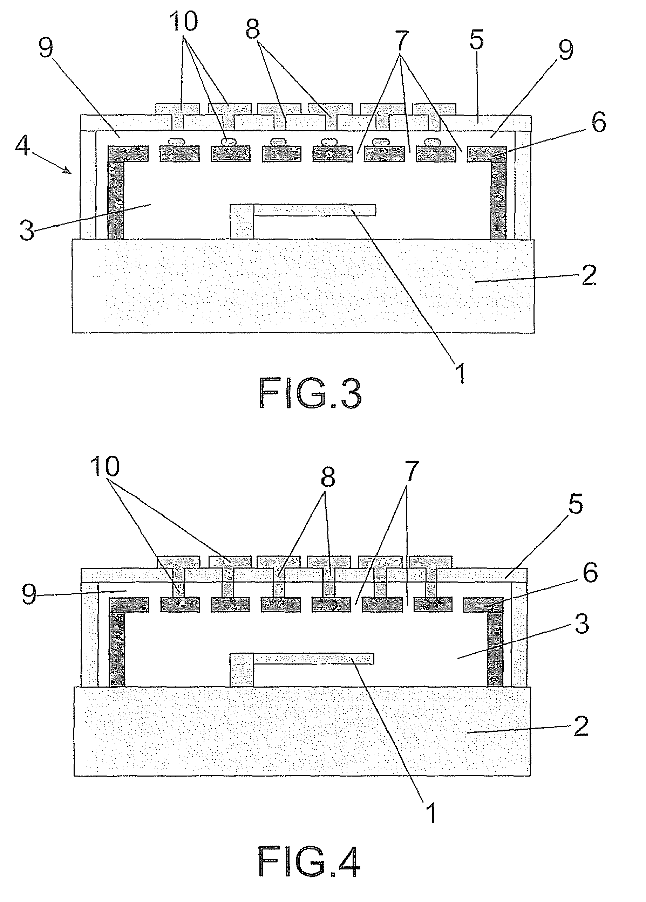

In the preferred embodiment of figures 3 and 4, the cap structure (4) includes two protective layers, a first protective layer (6) having a plurality of output holes (7) which provide access to the chamber (3), and a second protective layer (5) placed over said first protective layer (6), in such a manner that the channel (9) is formed between the first and the second protective layers (5,6).

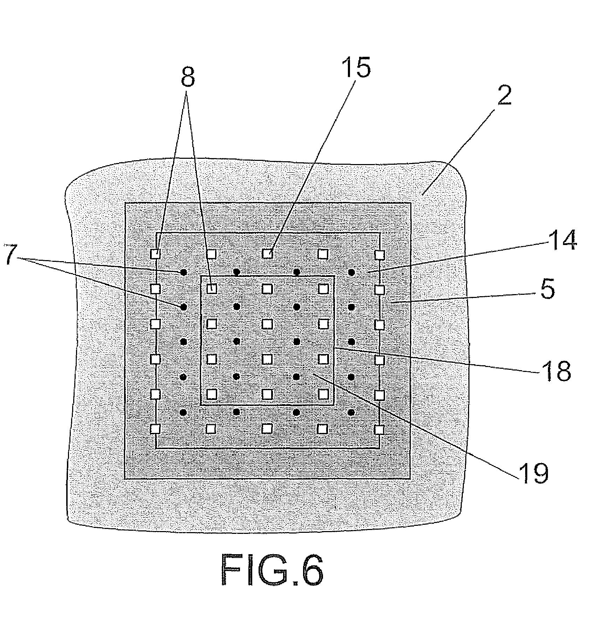

The second protective layer (5) is also provided with a plurality of input holes (8). Then it results that in said protective layers (6,5), solid areas (14) and holes areas (15) are defined, as shown in figure 6. The channel (9) communicates the holes (7) and (8) of both layers, and the holes (8) communicates, previously to the sealing process, the ambient with the channel (9).

In the preferred embodiments of figures 2,3,4 and 5, a major part of the first and the second protective layers (6,5) and the base substrate (2), are substantially parallel. A major part of the second protective layer (5) over the MEMS element (1), is placed at a selected distance over the first protective layer (6), so that the channel (9) extends all over the horizontal part of the first layer (6). A portion of the channel (9) is parallel to the base substrate (2).

As it can be observed for example in figures 3 and 4, the output holes (7) and input holes (8) respectively of the first and second protective layers (6,5) are arranged in such a manner that they do not overlap, that is no part of the holes (7) and (8) are superimposed. In other words, the whole area of the input holes (8) of the second protective layer (5) are superimposed to solid areas (14) of the first protective layer (6), and similarly the whole area of the output holes (7) of the first protective layer (6) are covered by solid areas of the second layer (5). With this arrangement, the solid areas of the first protective layer (6) acts as shields or masks, that close the access of the sealing material (10) to the chamber (3) through the input holes (8).

As represented in figures 3 and 4, the sealing material (10) will be deposited in the holes (8) of the second layer (6), and also part of this sealing material (10) could be deposited in the channel (9) on solid areas of the first protective layer (5). However, the sealing material (10) can not reach the output holes (7) of the first layer (5), because the sealing process is not capable of introducing sealing material through the channel (9), or due to the combination of the fluidic properties of the sealing material and the fluidic resistance of the channel (9), that avoids the entrance of the sealing material into the chamber (3). The dimensions of the channel (9) are selected depending on the fluidic properties of the sealing material (10) used in each particular case, to guarantee that the sealing material (10) does not reach the chamber (3).

The holes of both protective layers, are not aligned in substantially orthogonal direction to the planar surface of the base substrate (2), which at one hand, in view of figure 2, put a large area of sacrificial material (11) in contact with the etching solution (12) which flows through the paths represented by line (13) for releasing the MEMS element (1), while allowing a further sealing of the package to protect the MEMS element (1) but avoiding the entrance of sealing material (10) into the chamber (3). In this package, a large number of holes can be provided in the cap structure (4) even above the MEMS element (1), without the risk of the sealing material reaching the MEMS element (1).

As shown in figure 2, due to the large number of holes distributed in the first and the second protective layers (5,6) of the cap structure (4), the etching solution (12) reaches the sacrificial material (11), at multiple locations of the cap structure (4) even about the MEMS element (1), and consequently the sacrificial etching time is reduced and the risk of damage of the MEMS is minimized.

After the sacrificial material (11) has been eliminated by the etching solution (12) thereby releasing the MEMS element (1), a sealing material (10) is applied in a known manner on the second protective layer (5) closing the input holes (8) of this layer. The etching solution (12) due to its fluidity, is capable of flowing along the sinuous conduit formed by the channel (9) and the holes (7) and (8), however the sealing material (10) due to its viscosity and/or due to the fluidic resistance of the channel (9) can not flow along the channel (9) and then it can not reach the output holes (7) of the first protective layer (6). As a result, the sealing material (10) can not get access to the chamber (3), although discrete portions of sealing material (10) can be deposited on the solid areas of the first protective layer (6) as shown for example in figure 3, but without reaching the released MEMS.

Figure 4 shows the same package, but with an amount of sealing material enough to close the chamber (3) independently of the holes dimensions.

If the distance between both protective layers (6,5) is small enough, a low viscosity sealing material could also be used without the risk of reaching the device, even in the case of large holes.

The cap structure (4) after the sealing process has been finished, provides an hermetic, low-pressure environment within the chamber (3) to allow the operation of the MEMS element (1), and to protect the MEMS in subsequent wafer sawing and injection moulding processes.

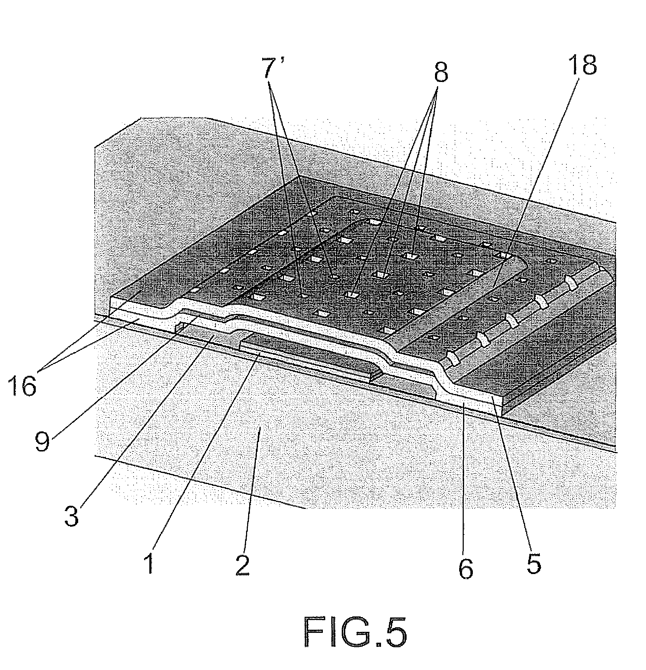

The anchoring of the cap structure (4) to the base substrate (2), can be obtained in different ways. In a first embodiment as the one shown in figures 2,3 and 4, each protective layer can be joined independently to the base substrate (2), so that there would be no contact between the different protective layers. Alternatively, the protective layers can be stacked together and only the lower layer is joined to the substrate. This is the case of the embodiment of figure 5, in which the first protective layer (6) is joined to the substrate (2), and the second protective layer (5) is joined to the first protective layer (6) on a perimetric bonding area (16) of the same. Also a combination of these alternatives can be implemented.

There could also be some regions of the package anchoring part where the package material relies on other layers than shown in the previous figures, like for example over sacrificial material or other, for example, dielectric materials. This could happen, for example, at locations where electrical connections leave out the package chamber.

As it can be observed for instance in figures 5 and 6, the first protective layer (6) has a rectangular shape and defines a flat perimetric bonding area (16) by means of which is joined to the base substrate (2), and an elevated central area (17) surrounded by the perimetric bonding area (16), which forms the chamber (3) on the base substrate (2). The second and additional protective layers may have the same configuration of the first protective layer (6) and are stacked on top of the fist protective layer (6).

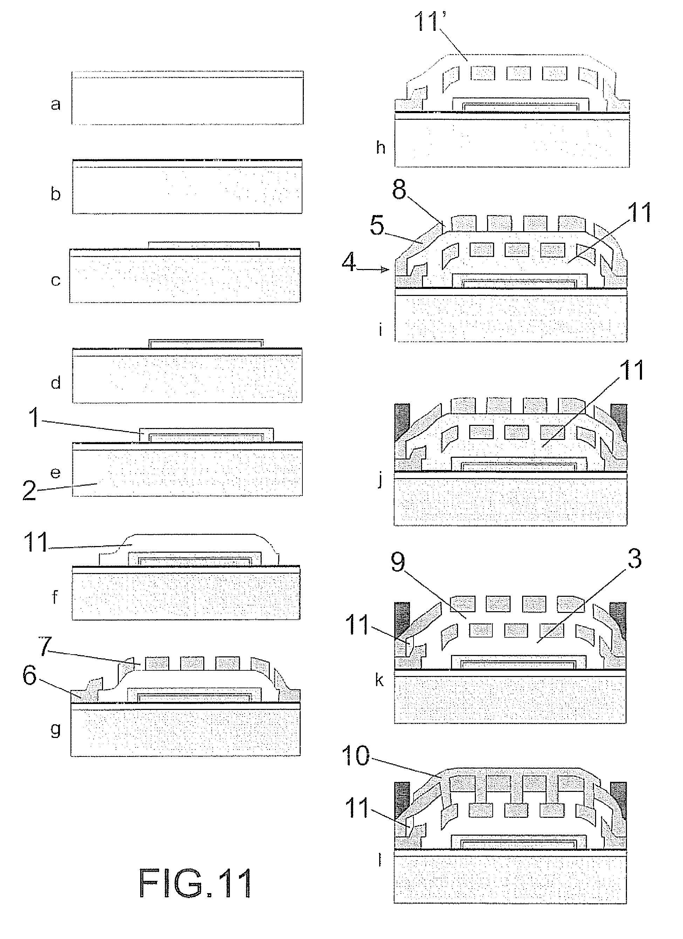

In figures 5,7 and 8, it can be observed that a perimetric step (18) is formed in each layer around the MEMS area (19), as a consequence of the conformal manufacturing process according to figure 11, in which the shape of the layers is adapted to the shape of the MEMS element (1).

The size, distribution and separation of the output and input holes (7,8) on each respective protective layer, are selected depending on the specific dimension of the elements of the cap structure (4), like layers thicknesses, distance between protective layers, technology processes characteristics, and etching and sealing processes. The minimum in-plane distance of the unaligned holes will depend on the distance between layers, thickness of the package layers and the specific process used for sealing the package. The maximum distance will also be limited by the etching rate of the etching process, as most of the sacrificial material concealing the MEMS to be released has to be etched.

Some preferred value ranges for the design of the cap structure are the following:
Protective layers thickness (hp): 0 < hp < 20µm
Thickness of the layer of
sealing material (hs): 0 < hs < 1mm
Hole in-plane diameter (1h): 0 < lh < 100µm
Distance between holes (dh): 0 < dh < 1mm
Maximum distance between package layers
(dplmx): 0 < dplmx < 20µm

One example of different holes distribution and size is shown in figures 5 and 6. The output holes (7) of the first protective layer (6) and the input holes (8) of the second protective layer (5), are evenly distributed on the corresponding layer in a reticulated fashion. However the location of holes on each layer, is displaced with respect to the other layer in such a manner that none of the holes of both protective layers overlap or are superimposed. In figure 5 the location of the output holes (7) of the first protective layer (6), is indicated by depressions (7') formed on the second protective layer (5) due the existence of the output holes (7).

In the embodiments of figures 5, 6 and 7, there are holes provided outside the MEMS area (18), however in other embodiments the holes may be only provided inside the MEMS area (18), because only the sacrificial material (11) surrounding the MEMS element (1), has to be released in order for the MEMS to operate properly. Then, after the etching process some sacrificial material (11) may remains in the chamber (3), spaced apart from the MEMS element (1).

The use of a cap structure (4) having several protective layers, minimize the problems commonly associated to prior-art thin-film encapsulation techniques, because the stiffness of the package is increased, thus reducing the risk of the cap structure (4) getting in contact with the MEMS as a result, for example, of a pressure difference between chamber (3) and outer ambient.

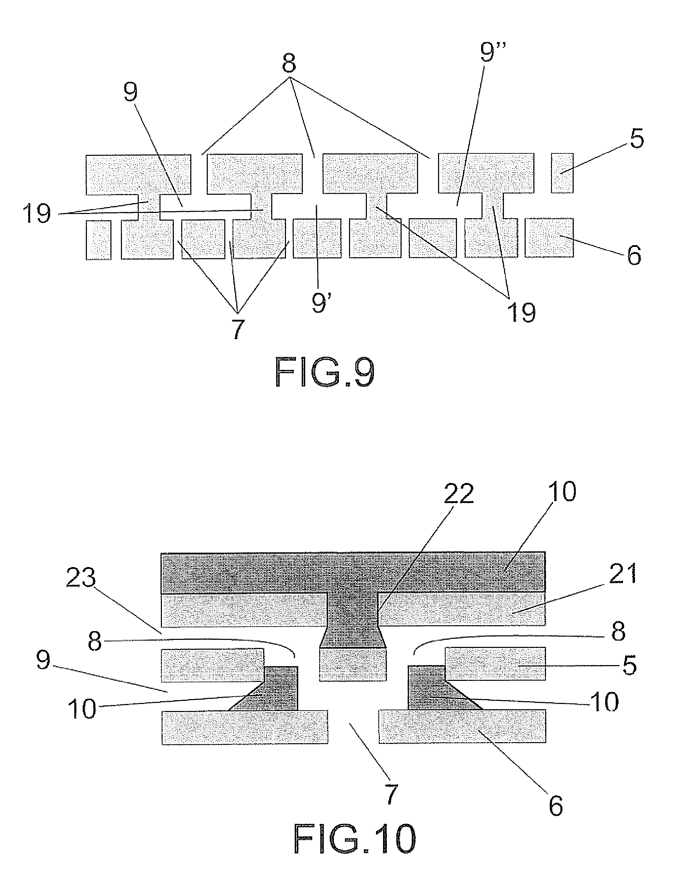

In order to increase the stiffness of the package even more, the different protective layers are brought together at different locations, such that the etching is still allowed. This particular embodiment is shown in detail in figure 9, in which some solid areas of the first and second protective layers (5,6) are physically connected by means of post or pillars (19) joined at their ends to both layers. The connection of the two protective layers at some locations, defines a plurality of channels (9,9',9'') for the passage of the etching solution.

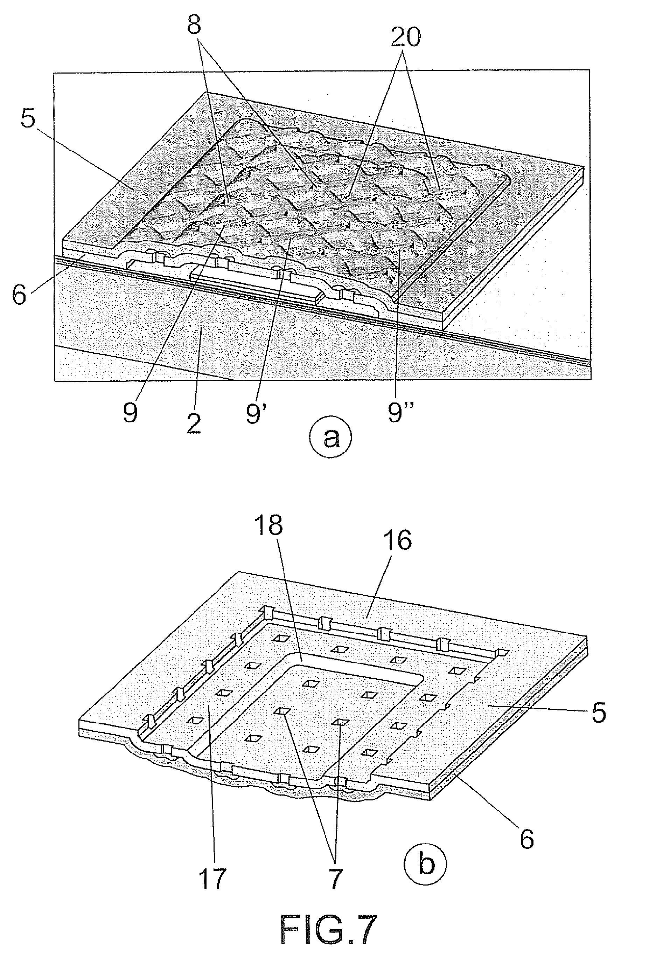

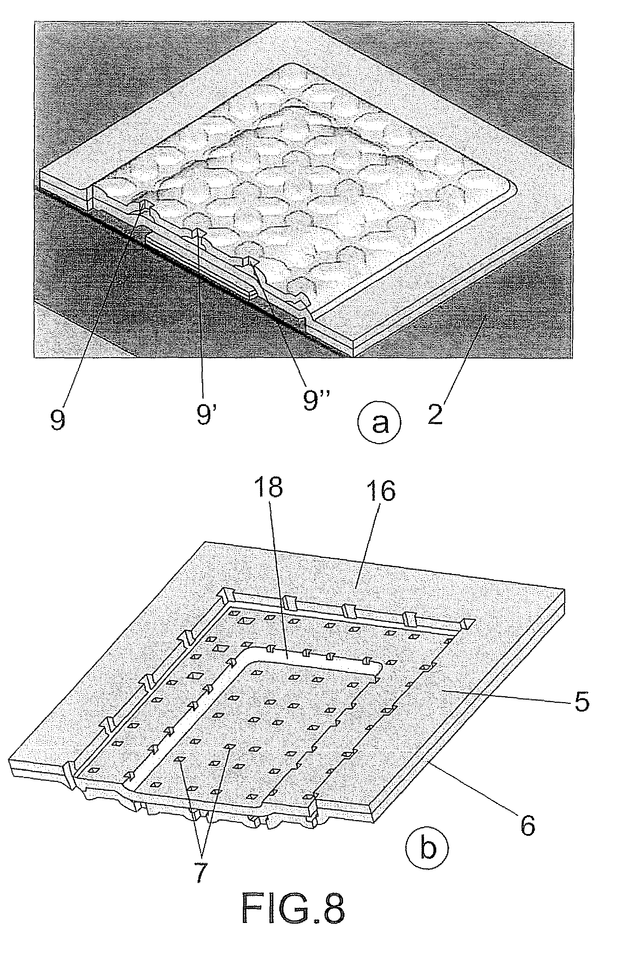

As shown in figures 7(a) and 8(a), the connection between both layers, can be also obtained by means of vias (20) of the second protective layer (6) which are in contact with the first protective layer (5). The material used to form the vias (20) can be the same or different than the material used to form the protective layers. The connection areas defined by the vias (20) between both protective layers, form interconnected channels (9,9',9'') which communicates several etching holes of both layers.

Alternatively, an intermediate layer between both protective layers, can be connected to both protective layers at selected locations, for example the location of the vias (20) in figure 7(a).

The connection of the different protective layers, increases significantly the rigidity of the cap structure (4) of the package.

The holes (7,8) can have any suitable shape and size. Preferably the holes have a square-like shape due to limitations of some technology process to control round shapes, although circular shapes can be used in other embodiments. Holes shapes and sizes can be different at the different protective layers, for example the input holes (8) of the second protective layer (6) may be larger than the output holes (7) of the first layer (5) as shown in figure 9. This is due to their different function. The first protective layer (6) is used to avoid the deposition of sealing material (10) over the MEMS, while the second and further protective layers are used for the deposition of the sealing material (10) and sealing of the package. This reason also explains the possibility to have a different distribution of holes at the different protective layers. The plurality of holes are distributed on each protective layer, to reduce the etching time of the sacrificial material (11) used to form the chamber (3).

In other preferred embodiments, the holes of the same protective layer may also have different sizes or shapes.

Also, outside the MEMS area (19), that is the area outside the perimetric step (18), the holes could be aligned in a substantially orthogonal direction to the substrate (2), because in that portion there is no risk of depositing sealing material (10) on the MEMS element (1). In this region outside MEMS area, the different layers can also be brought together to increase the rigidity of the package.

Figure 10 illustrates another preferred embodiment of the invention in which the cap structure (4) includes three protective layers, that is, a third protective layer (21) has been provided over the second protective layer (5). Some of the advantages obtained with a cap structure formed by more than two protective layers are the following:
- The minimum distance between unaligned etching holes can be reduced. In the case of three protective layers, the two lower protective layers can block the sealing material passing through the top layer more efficiently. This can, for example, reduce in some cases the distance between layers and reduce the length of the path that the etching solution has to follow from the top layer to the bottom layer to reach the sacrificial material, and consequently the etching time is also reduced.
- The rigidity of the package is increased.
- Reduced probability for the sealing material to reach the MEMS.

As it can be observed in figure 10, the sealing material (10) will be deposited on the outer surface of the third protective layer (21), and it will fills the holes (22) of this layer. The second protective layer (5), in this case acting as intermediate layer, acts as a mask for the holes (22) of the third layer (21). If some sealing material (10) passes through the holes (8) of the second layer (5), it will blocked by the first layer (6).

When the cap structure (4) includes three protective layers, the holes of two adjacent or consecutive protective layers, for example layers (5) and (6) or layers (5) and (21), do not overlap as shown in figure 10. However, the holes of the upper and lower layers, in this case the holes (7) of the first protective layer (6) and the holes (22) of the third protective layers (21), may overlap partially or completely. In this case, a second channel (23) is formed between the second and third layers, with similar function than the first channel (9), that is, to communicate the holes (22) and (8).

Different materials can be used as mechanical o functional (MEMS element), sacrificial, package cap and sealing components. A possible set of materials are:
- Sacrificial material: Silicon dioxide.
- Mechanical material: polysilicon, metals (like, for example, Al or a combination of Al and titanium nitride layers) or combinations of these materials.
- Package cap: Metals (like, for example, A1 or a combination of Al and titanium nitride layers), polysilicon, passivation materials (like silicon nitride), or combination of these materials.
- Sealing materials: Photoresist materials, passivation materials (like silicon nitride), metals, or combination of these materials.

Other set of materials could be the following:
- Sacrificial material: Polysilicon, photoresist or combination of these materials.
- Mechanical material: Silicon dioxide, silicon nitride, metals (like Al, Cr, Pt, gold) or combination of these materials.
- Package cap: Metals (like, for example, nickel, Al or a combination of Al and titanium nitride layers), passivation materials (like silicon nitride).
- Sealing materials: Photoresist materials, passivation materials (like silicon nitride), metals (like gold, silver, nickel, copper).

The MEMS package of the invention will form part of an integrated circuit in a known manner.

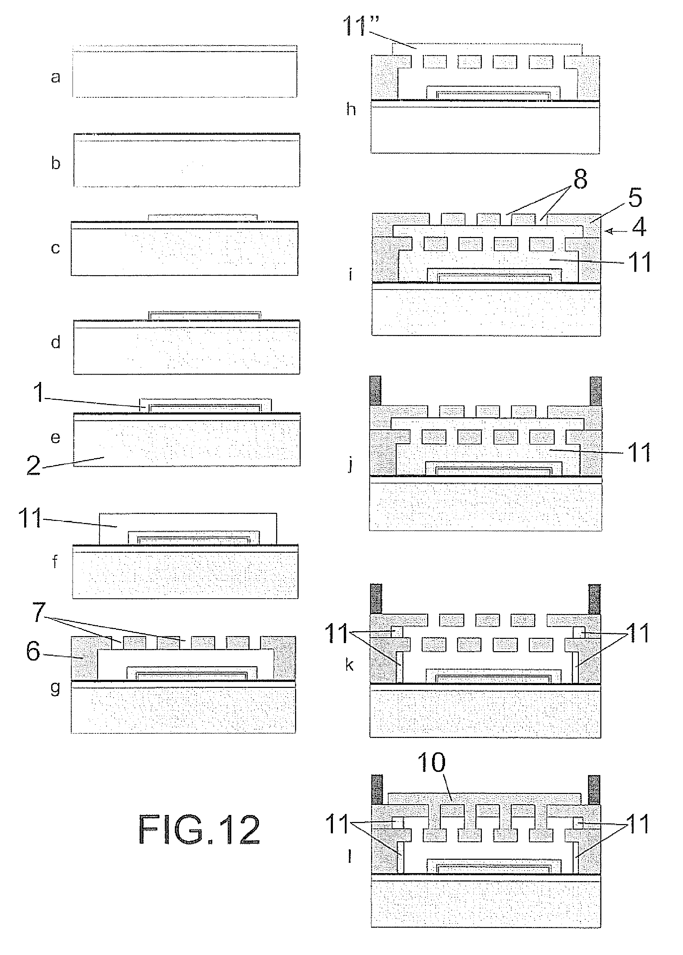

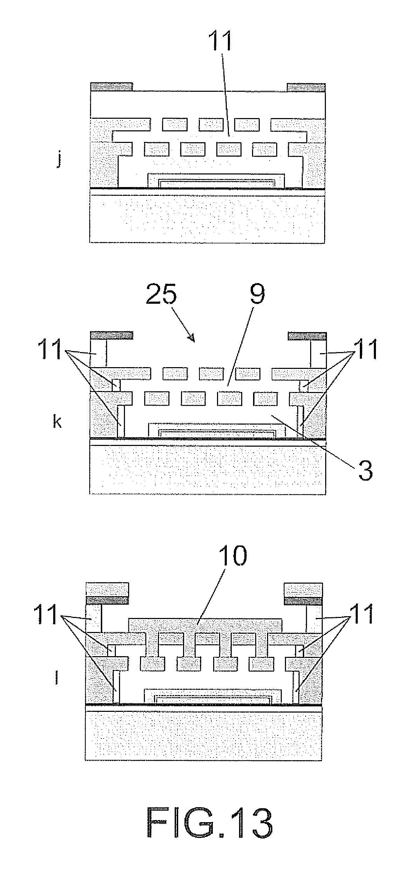

Figures 11, 12 and 13 illustrate a method for manufacturing at wafer-level a protective cap structure on a MEMS element. After a MEMS element (1) is formed in a known process on a surface of a base substrate (2) (figures 11 (a-e), 12 (a-e)), a sacrificial material (11) is deposited concealing the MEMS in order to support the subsequent construction of the cap structure (figures 11f,12f). Then, a first protective layer (6) is formed on said sacrificial material (11), joined to the base substrate (2) at a perimetric bonding area (16) of said protective layer (6) (figures 11g, 12g).

Additional sacrificial material (11'), is then deposited on the first protective layer (6) (figures 11h, 12h), for the construction of a second protective layer (5) (figures 11i, 12i), which in this case is mounted on the first layer (6) and it is formed at a selected distance from the first layer (5), to define a channel (9) during the etching of the sacrificial material (11,11).

Optionally, some openings can be formed at selected locations of the additional sacrificial material (11'), in order to form the vias (20) during the formation of the second protective layer (5).

The first and the second protective layers (6,5) are formed and then the output and input holes (7,8) are formed in a subsequent process. Alternately, the holes (7) and (8) can be formed during the construction of the protective layers. The holes of the first and second protective layers are provided at selected positions of the respective layers, so that they do not overlap. Additional protective layers can be formed over the second layer (5) be means of a similar constructive process.

The first and the second protective layers (6,5) can be formed using the same or different materials, for example the first protective layer (6) can be made of metal, and the second protective layer (5) can be a passivation layer of the package or a photoresist material deposited on top.

After the cap structure (4) has been formed, an etching solution is applied on the top layer, in this case the second protective layer (5), so that the etching solution will fill the input holes (8), the channel (9) formed between the layers (6) and (5) and the output holes (7), to eliminate at the same time the sacrificial material (11,11') and release the MEMS element (1) (figures 11k, 12k), which will be housed within a chamber (3) after the etching process.

Finally a sealing material (10) is deposited on the second protective layer (5) (figures 11 1, 12 1), to hermetically seal the MEMS package. The sealing material (10) fills the input holes (8) and part of the channel (9), but it is blocked by the first protective layer (6).

Most of the practical applications require the sealing of the package. However some types of MEMS only require to be physically protected, for example to avoid contact with an external object when they are being handled, but they do not need to operate under specific atmospheric conditions. Then, for this particular types of MEMS the package is not sealed.

This method also allows the sealing of the package by using a high viscosity material, but not because of using small holes (like some prior-art methods) but because of the high fluidic resistance of the channels (9,9',9') formed between both protective layers (5,6). This cap structure (4), allows the use of etching holes (7,8) of practically any size.

The sealing material (10) can be for example a SU-8 photoresists, which has enough viscosity. As the channels (9,9',9'') between the protective layers are usually quite narrow, and therefore its fluidic resistance is high, many of the types of the SU-8 photoresists can be used for this purpose. Other photoresist can also be used, like the AZ4562. Also, solder materials, like Sn or Sn/Pb have enough viscosity to be used as sealing material.

Although a dry release (etching) process is desirable because it can avoid stiction of the MEMS, also a wet release process can be used. Sealing can be performed in several different ways. One option is the use of a thick resist layer. Another option is the use of a usual passivation process.

The etching and sealing processes can be performed in two different ways: during the wafer fabrication process or as a post-process. In the first case, the etching and sealing processes have to be inserted within the usual process steps, after the deposition of the last package layer. In this case, a window opening (25) has to be included to form side walls to protect other parts of the wafer which should not be affected by the etching and sealing processes. This window (25) will usually be removed after sealing process is performed. In the second case, if the last deposited layer is the last layer of the package, no window opening is mandatory. Last deposited layer would make the function of window opening, If the last deposited layer is not the last package layer, a window opening would be needed, although not mandatory to eliminate. The second case has the advantage that there is no influence on the process flow of the usual fabrication steps. Only some additional steps are added after the usual processes, like window opening, sacrificial layer etching and sealing.

This packaging technique allows the design of the MEMS element, independently of the packaging process. Therefore, the MEMS element (1) can be any type of operational device, for example: pressure sensors, gyroscopes, tuneable capacitors, inductors, switches, resonators, micro-qyroscopes, micro-accelerometers, micro-actuators etc.

The packaging technique of the present invention has been described for the encapsulation of a single MEMS element, but the skilled person would understand that the same packaging technique can be used for the individual and simultaneous encapsulation of a plurality of MEMS elements formed on a host wafer.

Further embodiments of the invention, are described in the attached dependent claims.

## Claims

1. A MEMS package comprising a base substrate (2) and a cap structure (4) joined to said base substrate (2) forming a chamber (3) therewith, the package further comprising at least a MEMS element (1) formed on a base substrate (2) and housed within said chamber (3), **characterized in that** the cap structure (4) comprises at least one protective layer (24) having at least one input hole (8) on its upper surface and at least one output hole (7) on its lower surface, wherein the protective layer (24) includes at least one channel (9) which communicates said input and output holes (8,7) for the passage of an etching fluid (12) to said chamber (3), and wherein the input and output holes (8,7) are arranged in such a manner that they do not overlap.

2. A package according to claim 1 wherein at least one output hole (7) is located above the MEMS element (1).

3. A package according to claim 1 or claim 2 wherein at least one input hole (8) is located above the MEMS element (1).

4. A package according to any of the preceding claims wherein the cap structure (4) includes at least two layers, a first protective layer (6) having at least one output hole (7) which provides access to said chamber (3), and a second protective layer (5) having at least one input hole (8) and placed over said first protective layer (6), wherein the channel (9) is defined between said first and second protective layers (6,5) communicating said input and output holes (8,7).

5. A package according any of the preceding claims wherein the holes (8,7) on at least one of the protective layers (6,5,), are evenly distributed.

6. A package according to any of the preceding claims wherein the surface of base substrate (2) on which the MEMS element (1) is formed is substantially flat, and a major portion of the protective layers (6,5,21) above the MEMS element (1), are substantially parallel to said surface.

7. A package according to any of the preceding claims wherein the channel (9) and the input and output holes (8,7) of the first and the second protective layers (6,5), form a non-straight conduit in the cap structure (4) for the passage of an etching fluid (12), the dimensions of said conduit being adapted to prevent a sealing material (10) from entering into the chamber (3).

8. A package according to claim 7 wherein a portion of the channel (9) is substantially parallel to the base substrate (2).

9. A package according to any of the preceding claims wherein a part of the second protective layer (5) above the MEMS element (1), is placed at a selected distance from the first protective layer (6).

10. A package according to any of the preceding claims wherein the holes (7,8) have a circular, elliptical or polygonal shape, and the geometric centres of said holes are not aligned in a substantially orthogonal direction to the base substrate,

11. A package according to any of the preceding claims wherein at least one protective layer is joined to the base substrate (2) and it is not in contact with other protective layers.

12. A package according to any of the preceding claims wherein at least two protective layers are joined together at a perimetric bonding area (16) of said layers.

13. A package according to any of the preceding claims wherein not all the holes (7,8) have the same shape or size.

14. A package according to any of the preceding claims wherein the holes (7,8) are arranged in a reticular distribution on at least one of the protective layers (5,6).

15. A package according to any of the preceding claims wherein it includes a third protective layer (21) having at least one hole (22), said third protective layer (21) being placed over the second protective layer (5) defining a second channel (23) with said second protective layer (5), wherein said second channel (23) communicates the holes (22,8) of the third and second protective layers (5,22).

16. A package according to any of the preceding claims wherein at least two adjacent protective layers are physically connected at selected locations, wherein said locations do not include the holes of the protective layers.

17. A package according to claim 16 wherein it is provided with pillars (19) between two adjacent protective layers (5,6,21), wherein said pillars (19) are joined to said protective layers.

18. A package according to any of the preceding claims wherein a plurality of intercommunicated channels (9,9',9''), are defined between at least two adjacent protective layers (5,6,21), wherein each channel communicates a group of holes of said layers.

19. A package according to any of the preceding claims wherein the MEMS element (1) is hermetically housed within the chamber (3).

20. A package according to any of claims 1 to 14 wherein the holes (8) of the second protective layer (5) are closed by a sealing material (10).

21. A package according to claim 20 wherein discrete portions of sealing material (10) are deposited on the first protective layer (6), and the holes (7) of the first protective layer (6) above the MEMS element (1) are not filled with sealing material (10).

22. A package according to claim 15 wherein the holes (22) of the third protective layer (21) are closed by a sealing material (10).

23. A package according to claim 22 wherein discrete portions of sealing material (10) are deposited on the second protective layer (5), and the holes (8) of the second protective layer (5) above the MEMS element (1) are not filled with sealing material (10).

24. A package according to any of the preceding claims wherein the base substrate (2) is a semiconductor substrate.

25. A package according to any of the preceding claims wherein the MEMS element (1) is selected from the group comprising: a pressure sensor, a gyroscope, a tuneable capacitor, an inductor, a resonator, a micro-gyroscope, a micro-accelerometer, a micro-actuator, a micro-switch.

26. Integrated circuit including a MEMS package according to any of the preceding claims.

27. Method of manufacturing a MEMS package, comprising the steps of forming at least a MEMS element (1) on a base substrate (2),
depositing a sacrificial material (11) to conceal said MEMS element (1),
forming a cap structure (4) on said sacrificial material, said cap structure (4) being joined to said base substrate (2), wherein the cap structure (4) comprises at least one protective layer (24) having at least one input hole (8) on its upper surface and at least one output hole (7) on its lower surface, wherein the protective layer (24) includes at least one channel (9) communicating said input and output holes (8,7), and wherein the input and output holes (8,7) are arranged in such a manner that they do not overlap,
applying an etching fluid (12) to release the MEMS element (1) and form a chamber (3) inside which the MEMS element (1) is housed.

28. Method according to claim 27 wherein a sealing material is deposited to seal the input holes (8) of the cap structure (4).

29. Method according to claim 27 or claim 28 wherein the formation of the cap structure (4) comprises the steps of
providing a first protective layer (6) on said sacrificial material (11), said first protective layer (6) having at least one output hole (7),
providing at least a second protective layer (5) having at least one input hole (8), over said first protective layer (6), in such a manner that the channel (9) is defined between said first and second protective layers (6,5).

30. Method according to any of the claims 27 to 29 wherein the etching fluid (12) is applied through the input holes (8), the channel (9) and through the output holes (7).

31. Method according to any of the claims 27 to 30, wherein a sealing material (10) is deposited to fill the input holes (8), and wherein said sealing material (10) is not deposited in the output holes (7).
